# EUROPEAN PATENT APPLICATION

(11) **EP 2 632 238 A1**
(43) Date of publication of application: **28.08.2013**
(21) Application number: 11834393.8
(22) Date of filing: 19.10.2011
(51) Int. Cl.: H05K 5/02, F16B 13/08, F16B 13/12

(54) **WALL-MOUNTABLE DEVICE**

(30) Priority: 21.10.2010 JP 2010236630
(71) Applicant: Patlite Corporation, Osaka-shi, Osaka 542-0067 (JP)
(72) Inventor: NAITO, Yasuharu, Osaka-shi Osaka 542-0067 (JP); KOMA, Tomonori, Osaka-shi Osaka 542-0067 (JP)
(74) Representative: Witte, Weller & Partner
(86) International application number: PCT/JP2011/074057
(87) International publication number: WO 2012/053554

(57) **Abstract**

An insertion protrusion (11) of a frame (2) of a device (1) is inserted into an opening (101) in a wall (100). A first fastening portion (120) of the frame (2) faces a first wall surface (100a) of the wall (100). A first screw member (22; 22B) inserted into an insertion hole (20a) in the insertion protrusion (11) is threadedly engaged with a second screw member (23; 23A; 23B; 23C) on a screw axis (L1). By operating an operating portion (22; 36) of an operating mechanism (22; 22B; 35), the operating portion (22; 36) exposable from the frame (2) toward a first direction (X1), a rotational position of the second screw member (23; 23A; 23B; 23C) about the screw axis (L1) can be controlled between a first rotational position (P1) and a second rotational position (P2). The wall (100) is fastened directly or indirectly between the first fastening portion (120) of the frame (2) and a second fastening portion (280; 283) of the second screwmember (23; 23A; 23B; 23C) having been displaced to the first rotational position (P1).

## Description

### Technical Field

The present invention relates to a wall-mountable device.

### Background Art

For example, devices such as a speaker including a speaker horn, a driver driving the speaker horn, and a case accommodating these speaker horn and driver may be mounted in a wall opening in some cases. Patent Document 1 describes a configuration, as an electronic device, having a plate-like portion called a flange portion and a peripheral wall protruding rearward from a rear surface of the flange portion, for example. The peripheral wall has a square annular outer surface arranged behind the wall. The outer surface has one lateral surface formed with a locking hole for attaching a fitting. The locking hole is adopted so that a mounting bracket can be hung. The mounting bracket having been caught in the locking hole has a portion facing the flange portion across the wall. The portion is formed with a screw hole, with which a screw is configured to be engaged. The wall is held by the flange portion and the screw, whereby the electronic device is mounted on the wall.

A procedure for mounting the electronic device having such a configuration on the wall will be described. First, an operator inserts the electronic device without the mounting bracket into the opening in the wall from the front side of the wall. By this, the peripheral wall is arranged behind the wall and the flange portion abuts against a peripheral part of the opening in the wall. While the electronic device is fitted in the opening from the front side of the wall as above, the operator holds the electronic device with one hand, holding the mounting bracket with the other hand. In this state, the operator turns the other hand around the rear surface side of the wall and hangs the mounting bracket in the locking hole in the peripheral wall. Subsequently, the operator engages the screw with the screw hole in the mounting bracket. By this, the screw comes into contact with the rear surface side of the wall. As a result, the wall is held between a distal end of the screw and an outer peripheral portion of the flange portion, and the electronic device is fixed to the wall.

To detach the electronic device, a reverse procedure to the above is performed. That is, the operator loosens the screw from the rear surface side of the wall, and then, detaches the mounting bracket from the locking hole in the electronic device. After that, the operator pulls the electronic device out of the opening in the wall.

### Prior Art Documents

### Patent Documents

Patent Document 1: Japanese Unexamined Patent Publication No. 2005-64103

### Summary of the Invention

### Problems to be Solved by the Invention

However, the configuration described in Patent Document 1 involves a lot of trouble with operations of attaching and detaching the electronic device to and from the wall. Specifically, the electronic device is attached and detached to and from the opening in the wall from the front side of the wall while attachment and detachment of the mounting bracket and the screw from the rear surface side of the wall are required. As above, the operations at both sides across the wall, that is, the operation at the front side of the wall and the operation at the rear surface side of the wall are required. Accordingly, it is necessary to turn hands around both sides across the wall, which is troublesome.

It is also conceivable that the attaching and detaching operations of the mounting bracket and the screw may be performed at the rear surface side of the wall in the state of temporarily securing the electronic device by a tape fastener, when the electronic device is attached and detached to and from the wall. However, the temporary securing operation is required and involves a lot of trouble, just the same. If the wall is large, hands cannot be turned around the front and the rear surface side of the wall. As a result, a one-man operation is in practice difficult. Accordingly, the electronic device needs to be mounted on the wall by two persons, and it inevitably involves a lot of trouble.

The present invention was made against such a background and an object thereof is to provide a device whose attaching and detaching operations with respect to the wall are easy.

### Means for Solving the Problems

In order to achieve the foregoing object, the first aspect of the present invention provides a wall-mountable device that is mountable on a wall having a first wall surface directed to a first direction and a second wall surface directed to a second direction as the opposite direction of the first direction and formed with an opening penetrating the first wall surface and the second wall surface. The device is provided with a frame, a first screw member and a second screw member coupled to each other on a screw axis in order to attach the frame to the wall, and an operating mechanism including an operating portion exposable from the frame toward the first direction, the operating mechanism being capable of controlling a rotational position of the second screw member about the screw axis between a first rotational position and a second rotational position by operating the operating portion. The frame includes an opposed portion arranged so as to face the first wall surface of the wall and an insertion protrusion protruding from the opposed portion toward the second direction and being insertable into the opening. The opposed portion has a first fastening portion configured to face a periphery of the opening in the first wall surface. The insertion protrusion forms an insertion hole extending along the screw axis. The first screw member is inserted into the insertion hole along the second direction and threadedly engaged with the second screw member. The second screw member includes a second fastening portion configured to face the first fastening portion at the first rotational position and avoid facing the first fastening portion at the second rotational position. The wall is fastened directly or indirectly between the first fastening portion of the opposed portion and the second fastening portion of the second screwmember having been displaced to the first rotational position.

As in the second aspect of the present invention, the second screw member may include a relatively distant part and a relatively near part from the screw axis, and the relatively distant part may include the second fastening portion.
As in the third aspect of the present invention, the operating mechanism may include a male screw member as the first screw member and threadedly engaged with a female screw member as the second screw member, and the male screw member as the operating mechanism may be configured to be capable of controlling a position of the female screw member via a frictional engagement force between the male screw member and the female screw member.

As in the fourth aspect of the present invention, the operating mechanism may include an operating member integrally rotatably coupled to the second screw member, and the operating member may extend from the second screw member toward the first direction through the insertion hole in the insertion protrusion.
As in the fifth aspect of the present invention, the frame may include a stopper portion for holding the second screw member at the first rotational position.

As in the sixth aspect of the present invention, the frame may include a stopper portion for holding the second screw member at the second rotational position.
As in the seventh aspect of the present invention, the insertion protrusion may have an outer surface, part of which is formed with a housing recess housing the second screw member, and the stopper portion may be arranged within the housing recess.

As in the eighth aspect of the present invention, the female screw member as the second screw member may include a cylindrical portion having a female screw portion engaged with the male screw member as the first screw member, and an extension portion extending radially outward from the cylindrical portion, and the second fastening portion may be provided to the extension portion.
As in the ninth aspect of the present invention, the frame may include a holding portion rotatably holding the cylindrical portion.

### Effects of the Invention

According to the first aspect of the present invention, an operator can attach and detach the device to and from the wall only with an operation from the first wall surface side of the wall. Therefore, the labor involved to attach and detach the device can be significantly lessened. Specifically, first, the operator inserts the insertion protrusion of the frame of the device into the opening in the wall from the first wall surface side along the second direction in the state where the second screw member is arranged at the second rotational position, and also the operatormakes the first fasteningportion of the opposed portion of the frame face the periphery of the opening in the first wall surface of the wall. Subsequently, the operator operates the operating portion of the operating mechanism from the first wall surface side of the wall, thereby displacing the second screw member to the first rotational position. As a result, the second fastening portion of the second screw member faces the first fastening portion of the opposed portion of the frame. In this state, the operator rotates the first screw member from the first wall surface side of the wall by use of a tool, and the operator fastens the wall directly or indirectly between the first fastening portion and the second fastening portion. Then, the device can be easily mounted on the wall. To demount the device having been mounted on the wall from the wall, a reverse operation to the above is carried out.

According to the second aspect of the present invention, the second fastening portion of the second screw member is provided to the relatively distant part from the screw axis, so that the second fastening portion can be configured easily.
According to the third aspect of the present invention, the male screw member as the first screw member serves as the operating mechanism as well. Therefore, there is no need to operate the male screw member and the member for controlling the rotational position of the female screw member as the second screw member separately, so that the labor at the time of attaching and detaching the device to and from the wall can be further saved. Additionally, the number of parts of the device can be further reduced.

According to the fourth aspect of the present invention, the rotational position of the second screw member can be controlled by the simple configuration of using, as the operating mechanism, the operating member integrally rotatably coupled to the second screw member.
According to the fifth aspect of the present invention, the second screwmember located at the first rotational position can be restricted from further rotating when the first screw member is rotated to mount the device on the wall. Then, the second screw member can be held at the first rotational positionreliably. Accordingly, the operator who performs the mounting operation of the device from the first wall surface side of the wall can arrange the second screw member at the first rotational position reliably even if being unable to see the rotation direction position of the second screw member arranged at the second wall surface side of the wall. The operator can perform the mounting operation of the device without anxiety even if being unable to see the second screw member, and the labor of mounting the device can be further saved.

According to the sixth aspect of the present invention, the second screw member located at the second rotational position can be restricted from further rotating when the first screw member is rotated to detach the device from the wall. Then, the second screw member can be held at the second rotational position reliably. Accordingly, the operator who performs the detaching operation of the device from the first wall surface side of the wall can arrange the second screw member at the second rotational position reliably even if being unable to see the rotation direction position of the second screw member arranged at the second wall surface side of the wall. Therefore, the second screw member can be reliably prevented from catching on the wall when the device is detached, even if the operator cannot see the second screw member, and the labor of demounting the device can be further saved.

According to the seventh aspect of the present invention, the second screw member and the stopper portion can be prevented from projecting outward from the insertion portion by housing the second screw member in the housing recess and arranging the stopper portion within the housing recess. This can reliably prevent the second screw member from facing the opposed portion of the frame when the second screw member is located at the second rotational position. Accordingly, the second screw member can be more reliably prevented from being caught when the frame of the device is inserted into the wall, and the labor of mounting the device can be further saved. In addition, the device can be further downsized. Moreover, the thickness of the insertion portion can be reduced, so that a reduction in thickness of the device can be achieved.

According to the eighth aspect of the present invention, the length of the female screw portion can be increased by forming the female screw portion at the cylindrical portion. Then, the contact area between the male screw member and the female screw member can be further enlarged, so that the frictional engagement force between the male screw member and the female screw member can be sufficiently ensured. Thus, the female screw member can be reliably rotated when desired to be rotated along with the rotation of the male screw member. Accordingly, the labor of mounting the device can be further saved.

According to the ninth aspect of the present invention, the screw axis as the central axis of the male screw member and the female screw member can be prevented from swaying while the male screw member and the female screw member are rotated. Thus, the male screw member and the female screwmember can be rotated smoothly. The labor of mounting the device can be further saved.

### Brief Description of the Drawings

[FIG. 1] FIG. 1A is a perspective view showing a device according to one embodiment of the present invention and a wall on which the device is mounted, and FIG. 1B is a perspective view of the device and shows a state that a cover of the device is slid.
[FIG. 2] FIG. 2A is a plan view when the state of the device being mounted on the wall is viewed from the above, and FIG. 2B is a rear view when the state of the device being mounted on the wall is viewed from the rear.
[FIG. 3] FIG. 3 is a cross-sectional view taken along the line III-III of FIG. 2B and shows a cross section of the device when viewed from the left.
[FIG. 4] FIGS. 4A and 4B are diagrams for explaining attaching and detaching of the device with respect to the wall.
[FIG. 5] FIG. 5 illustrates another mounting mode for mounting the device on the wall as a reference form of the present invention and is a cross-sectional view of the device and the wall.
[FIG. 6] FIG. 6 is a cross-sectional view of a main part of a device showing another embodiment of the present invention.
[FIG. 7] FIG. 7 is a cross-sectional view of a main part of a device showing further another embodiment of the present invention.
[FIG. 8] FIG. 8 is a diagram of a main part of a device showing still further another embodiment of the present invention, and FIG. 8A is a cross-sectional view of the main part when a female screw member is located at a second rotational position, and FIG. 8B is a perspective view of the female screw member, and FIG. 8C is a cross-sectional view of the main part when the female screw member is located at a first rotational position.
[FIG. 9] FIG. 9 is a rear view when a main part of a device showing still further another embodiment of the present invention is viewed from the rear, and FIG. 9A shows a state of a female screw member being located at the first rotational position, and FIG. 9B shows a state of the female screw member being located at the second rotational position.

### Modes for Carrying Out the Invention

Hereinafter, embodiments of the present invention will be described specifically with reference to the drawings.

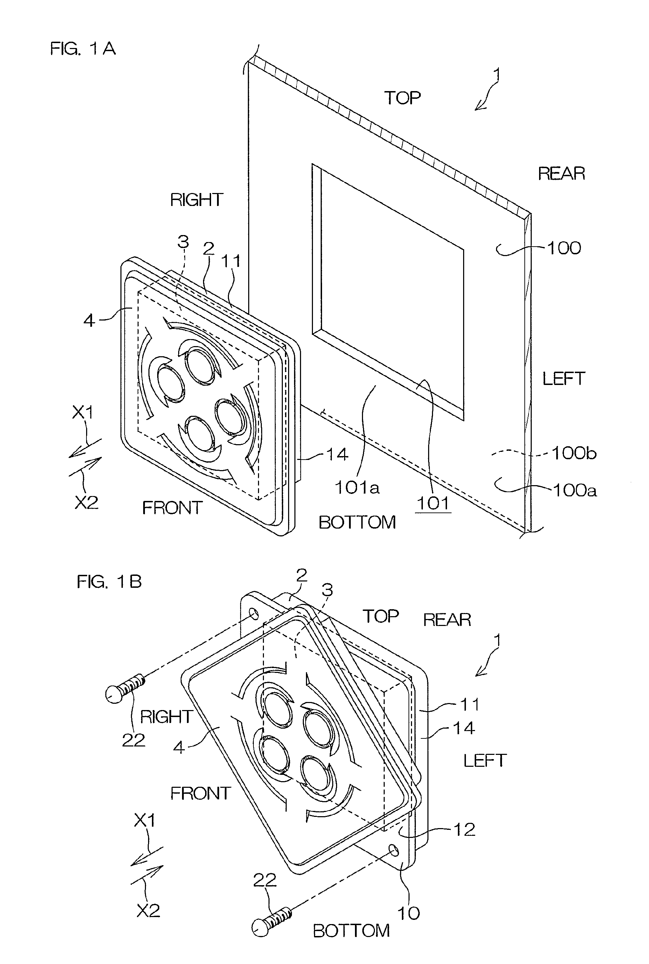

FIG. 1A is a perspective view showing a device according to one embodiment of the present invention and a wall on which the device is mounted. FIG. 1B is a perspective view of the device and shows a state that a cover of the device is slid.
A device 1 is a speaker device for producing sound such as a warning sound, for example. It is noted that the speaker device is taken as an example and described as the device 1 but the present invention can also be applied to other devices other than the speaker device, and in particular to electronic devices.

The device 1 is configured to be mounted on an opening 101 in a wall 100. More specifically, the wall 100 is, for example, a front door of a case which accommodates a control panel of a machine tool. The opening 101 is, for example, a hole formed into a rectangular shape and penetrating the wall 100. In this embodiment, up-down, left-right, and front-rear directions shall be defined based on a state viewed from a rear wall surface 100b as the second wall surface of the wall 100.

The operator can attach and detach the device 1 to and from the opening 101 from a front wall surface 100a side as the first wall surface of the wall 100.
The device 1 includes a frame 2, a speaker unit 3 accommodated in the frame 2, and a cover 4 attached in the front X1 as the first direction of the frame 2.
The frame 2 is formed by using synthetic resin. The speaker unit 3 includes a speaker horn for producing sound, a driver for driving the speaker horn, and a memory unit connected to the driver. The speaker unit 3 is configured to produce sound from the speaker horn based on data stored in the memory unit. The memory unit is a memory card or the like removable from the driver. The device 1 is detached from the wall 100 at the time of exchange of memory cards.

The cover 4 is arranged in the front X1 (the first direction) of the frame 2 so as to cover a front surface of the frame 2. The cover 4 is also attached slidably with respect to the frame 2. The cover 4 is configured to be turnable clockwise and counterclockwise with respect to the frame 2 in a front view (when viewed from the front wall surface 100a side of the wall 100). Therefore, the cover 4 is displaceable between a position of covering the entire front surface of the frame 2 (see FIG. 1A) and a position of exposing four corners of the frame 2 to the front wall surface 100a side of the wall 100 (the front X1 of the wall 100) (see FIG. 1B) in a front view.

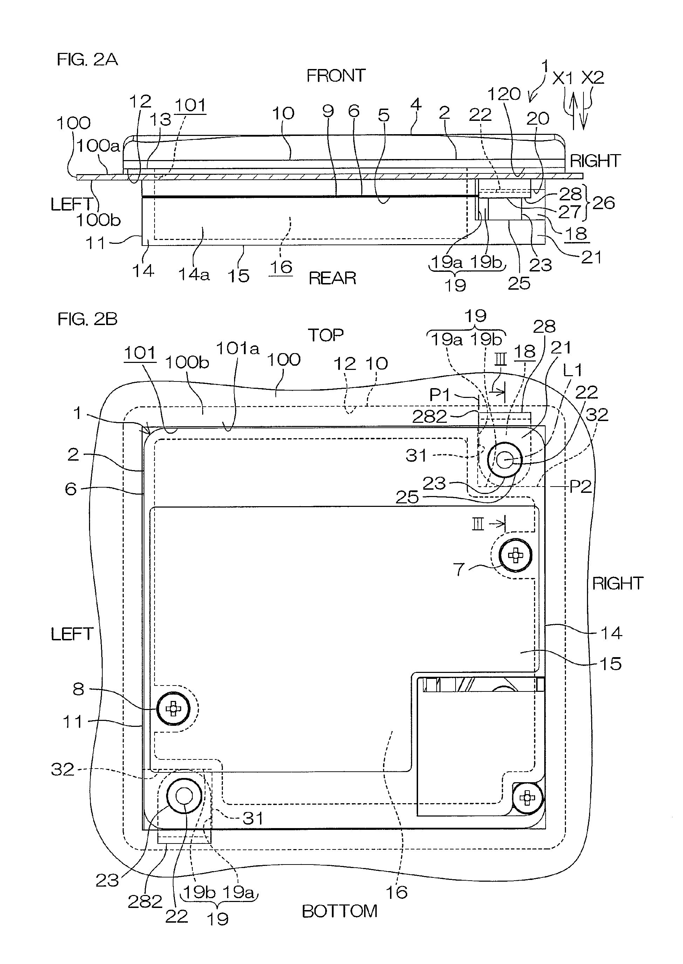

FIG. 2A is a plan view when the state of the device 1 being mounted on the wall 100 is viewed from the above, and FIG. 2B is a rear view when the state of the device 1 being mounted on the wall 100 is viewed from the rear. The frame 2 has two half body members 5 and 6 divided in the front-rear direction. The frame 2 is formed by coupling these two half body members 5 and 6 to each other by locking screws 7 and 8. A boundary surface 9 between the half body member 5 and the half body member 6 is located at the rear wall surface 100b side of the wall 100 and extends substantially vertically.

The frame 2 includes a front wall 10 arranged at the front wall surface 100a side of the wall 100 and an insertion protrusion 11 extending from the front wall 10 toward the rear X2 and extending toward the rear wall surface 100b of the wall 100 through the opening 101 in the wall 100.
The device 1 is fixed to the wall 100 at a right upper portion and a left lower portion thereof. A configuration for fixing the right upper portion of the device 1 with the wall 100 and a configuration for fixing the left lower portion of the device 1 with the wall 100 are the same. Accordingly, in the following, the configuration for fixing the right upper portion of the device 1 with the wall 100 will be mainly described and a detailed description of the configuration for fixing the left lower portion of the device 1 with the wall 100 is omitted.

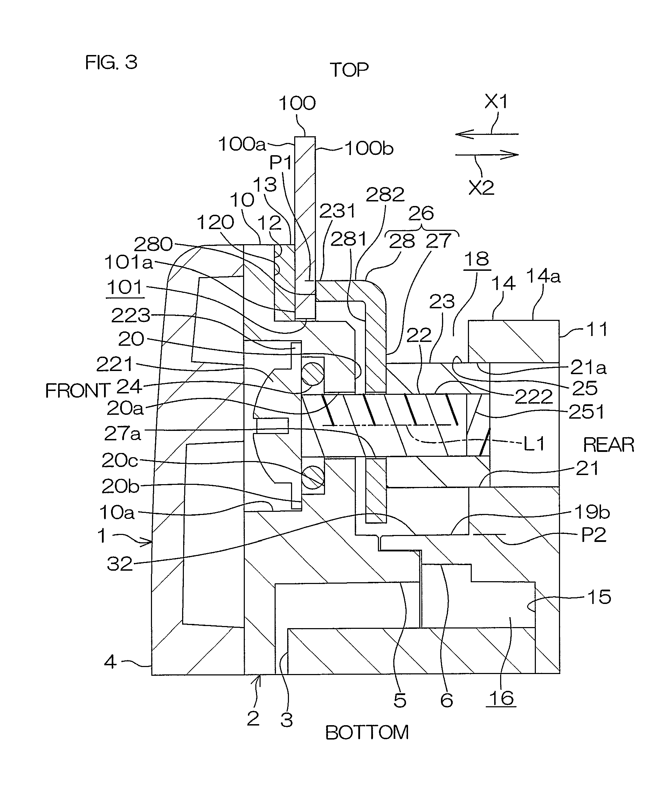

FIG. 3 is a cross-sectional view taken along the line III-III of FIG. 2B and shows a cross section of the device 1 when viewed from the left. The front wall 10 is formed into a rectangular flat plate shape and has a central portion formed with a hole (not shown) for allowing sound to pass through the speaker horn of the speaker unit 3. The front wall 10 is provided with a flanged opposed portion 12 (a peripheral portion). The opposed portion 12 is opposed to the front wall surface 100a of a peripheral portion 101a of the wall 100 in the front-rear direction. The opposed portion 12 is opposed to the front wall surface 100a of the peripheral portion 101a over the entire periphery. Part of the opposed portion 12 constitutes a first fastening portion 120 described later.

A packing 13 formed by using an elastic member such as rubber is arranged between the opposed portion 12 and the front wall surface 100a. Thus, the frame 2 and the wall 100 are sealed liquid-tight, thereby restricting foreign matter such as moisture from passing between the frame 2 and the wall 100. Referring to FIG. 2B and FIG. 3, the insertion protrusion 11 is a portion into which the opening 101 is inserted when the device 1 is mounted on the wall. The insertion protrusion 11 extends from the front wall 10 toward the rear X2 as the second direction (toward the rear wall surface 100b of the wall 100).

The insertion protrusion 11 includes a peripheral wall 14 formed into a substantially rectangular shape in a rear view (when viewed from the rear wall surface 100b of the wall 100) and a rear wall 15 covering a rear end of the peripheral wall 14. The front wall 10, the peripheral wall 14, and the rear wall 15 form a housing space 16 housing the speaker unit 3.
A housing recess 18 is formed at a right upper portion of the peripheral wall 14 by recessing part of an outer surface 14a of the peripheral wall 14. The housing recess 18 is substantially rectangular when viewed from the rear. More specifically, the housing recess 18 is comprised of an L-shaped lateral surface 19 formed at a right upper portion of the outer surface 14a of the peripheral wall 14, a seat 20 provided at the right upper portion of the peripheral wall 14, and a receiving portion 21 provided at a right upper portion of the rear wall 15 and opposed to the seat 20 in the front-rear direction.

The L-shaped lateral surface 19 includes a first surface 19a extending vertically and a second surface 19b extending toward the right from a lower end of the first surface 19a. Referring to FIG. 3, the seat 20 is formed with a screw insertion hole 20a. The seat 20 has a front surface formed with a seat surface 20b. The seat surface 20b is formed with an annular step 20c encompassing the screw insertion hole 20a. The screw insertion hole 20a can be exposed forward of the frame 2 via a through hole 10a formed in the front wall 10. The through hole 10a and the screw insertion hole 20a can be exposed forward of the device 1 by sliding the cover 4. The receiving portion 21 is formed with a holding hole 21a as a holding portion and lying coaxial with the screw insertion hole 20a.

The device 1 further includes a male screw member 22 inserted into the screw insertion hole 20a and as a first screw member and a female screw member 23 held in the holding hole 21a and as a second screw member. The male screw member 22 and the female screw member 23 are arranged at a right upper portion of the frame 2 so that the frame 2 can be attached to the wall 100 detachably. The male screw member 22 and the female screw member 23 are threadedly engaged with each other on a screw axis L1, thereby being coupled to each other.

The male screw member 22 as the first screw member has a function as a male screw and a function as an operating mechanism operating the female screw member 23 and can control a rotation direction position of the female screw member 23. The male screw member 22 extends from the front toward the rear of the frame 2 (from the front wall surface 100a side toward the rear wall surface 100b side of the wall 100). The male screw member 22 includes a head portion 221 as an operating portion and a male screw portion 222 extending from the head portion 221 toward the rear X2. The head portion 221 is arranged within the through hole 10a. The male screw portion 222 is arranged at the front side of the frame 2 (the front X1 of the wall 100) and can be exposed to the front X1 of the frame 2. An annular flange portion 223 is formed between the head portion 221 and the male screw portion 222. The flange portion 223 is in contact with the seat surface 20b.

A seal member 24 such as an O-ring is arranged between the flange portion 223 and the annular step 20c, thereby preventing foreign matter such as moisture from entering from between the male screw member 22 and the frame 2. The male screw portion 222 is inserted through the screw insertion hole 20a and extends to the housing recess 18. The male screw portion 222 is threadedly engaged with the female screw member 23 within the housing recess 18.

The female screw member 23 is provided to hold the wall 100 in cooperation with the opposed portion 12 of the frame 2 thereby to fix the frame 2 to the wall 100. The female screw member 23 includes a cylindrical portion 25 and a small piece portion 26 fixed to the cylindrical portion 25. It is noted that the small piece portion 26 and the cylindrical portion 25 may be comprised of a single material.
The cylindrical portion 25 is, for example, a long cylindrical member having an entire length longer than a diameter thereof. The cylindrical portion 25 has an inner circumferential surface formed with a female screw portion 251. The female screw portion 251 is threadedly engaged with the male screw portion 222 of the male screw member 22 at the rear of the screw insertion hole 20a. A frictional engagement force is exerted between the male screw portion 222 and the female screw portion 251. Thus, by rotationally operating the male screw member 22, the female screw member 23 can also rotate in conjunction. The male screw member 22 can control a rotation direction position of the female screw member 23.

A rear portion of the cylindrical portion 25 is inserted into the holding hole 21a as the holding portion of the receiving portion 21 and is rotatably supported to the holding hole 21a. The cylindrical portion 25 is opened to a back surface of the rear wall 15 of the frame 2, that is, the rear surface of the device 1.
The small piece portion 26 is formed into an L shape. The small piece portion 26 is displaceable between the seat 20 and the receiving portion 21 with respect to the front-rear direction. Thus, the small piece portion 26 is displaceable in the front-rear direction in the range of, for example, 1 to 5 mm.

The small piece portion 26 includes a flat plate portion 27 adjoining the cylindrical portion 25 and an extension portion 28 extending outward in the radial direction of the female screw member 23 from the flat plate portion 27. The flat plate portion 27 is formed with a screw insertion hole 27a into which the male screw member 22 is inserted. The extension portion 28 includes a first part 281 continuing to the flat plate portion 27 and a second part 282 formed by bending a distal end of the first part 281 and extending in the front-rear direction.

An end surface of the second part 282 of the extension portion 28 of the female screw member 23 constitutes a second fastening portion 280. The second part 282 corresponds to a relatively distant part from the screw axis L1, and the cylindrical portion 25 corresponds to a relatively near part from the screw axis L1.
As shown in FIG. 2B and FIG.3, the second part 282 is arranged outside the housing recess 18 (the peripheral wall 14) and abuts against the rear wall surface 100b of the wall 100 in a rear view, when the device 1 is fixed to the wall 100. The second part 282 and the opposed portion 12 are opposed to each other in the front-rear direction and sandwich the packing 13 and the wall 100 therebetween.

With the foregoing configuration, an external shape 231 of the female screw member 23 is not uniform in length from the screw axis L1 when viewed from the rear.
A rotation direction position of the female screw member 23 when the second fastening portion 280 provided to the second part 282 of the extension portion 28 of the female screw member 23 and the first fastening portion 120 provided to the opposed portion 12 of the frame 2 are opposed to each other in the front-rear direction across the wall 100 is defined as a first rotational position P1. That is, the second fastening portion 280 which is part of the external shape 231 of the second part 282 of the extension portion 28 of the female screw member 23 is opposed to the first fastening portion 120 of the opposed portion 12 in the front-rear direction when the female screw member 23 is located at the first rotational position P1.

The frame 2 includes a first stopper portion 31 for holding the female screw member 23 at the first rotational position P1 and a second stopper portion 32 for holding the female screw member 23 at a second rotational position P2 described later. Each stopper portion 31, 32 is arranged within the housing recess 18.
The first stopper portion 31 is formed on the first surface 19a of the L-shaped lateral surface 19 of the peripheral wall 14. The first stopper portion 31 makes contact with the extension portion 28 of the female screw member 23, thereby being able to restrict the female screw member 23 from further rotating toward the first stopper 31 (the counterclockwise direction in FIG. 2B).

The second stopper portion 32 is formed on the second surface 19b of the L-shaped lateral surface 19 of the peripheral wall 14. The second stopper portion 32 makes contact with the extension portion 28 of the female screw member 23, thereby being able to restrict the female screw member 23 from further rotating toward the second stopper portion (the clockwise direction in FIG. 2B).
Next, mounting and demounting of the device 1 with respect to the wall 100 will be described. An operator can attach and detach the device 1 to and from the wall 100 easily only with an operation from the front wall surface 100a side of the wall 100 without working at the rear wall surface 100b side of the wall 100.

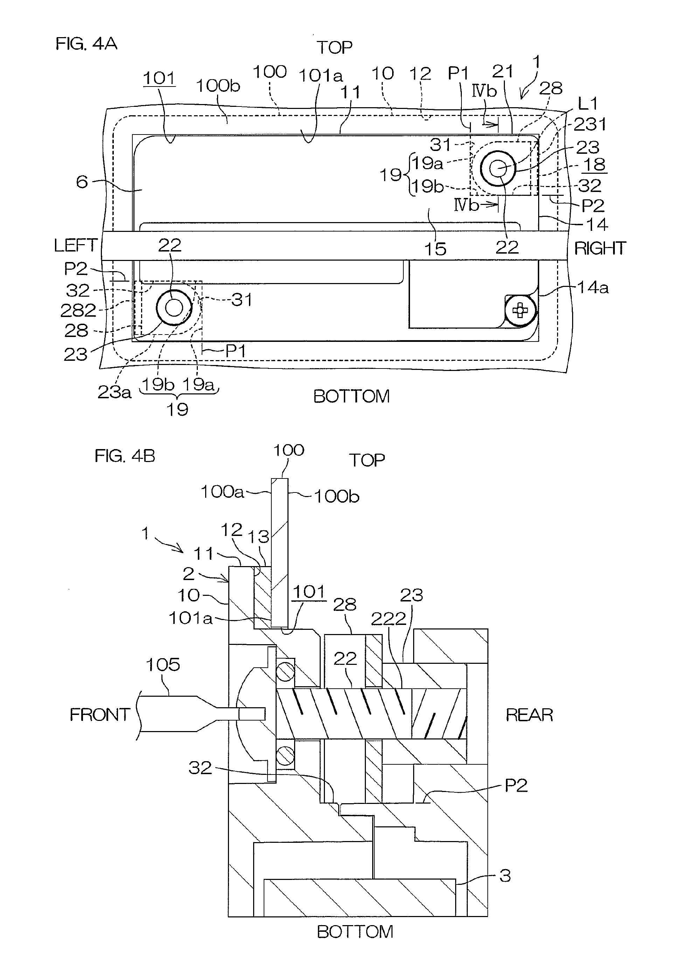

Referring to FIG. 1A, when mounting the device 1 on the wall 100, first, the operator holds the device 1 by hand (not shown) and stands in front of the wall 100. Subsequently, the operator inserts the insertion protrusion 11 of the frame 2 into the opening 101 from the front of the wall 100 toward the rear X2. At this time, the female screw member 23 is located at the second rotational position P2 as shown in FIG. 4A, and does not project from the insertion protrusion 11 of the frame 2 in a rear view.

More specifically, the female screw member 23 is located at the second rotational position P2 in which the external shape 231 of the female screw member 23 and the opposed portion 12 of the front wall 10 are pretended from facing each other in the front-rear direction. At this time, the extension portion 28 of the female screw member 23 is in contact with the second stopper portion 32. The female screw member 23 is arranged within an area surrounded by the insertion protrusion 11 when viewed from the rear. Accordingly, the female screw member 23 does not catch on the opening 101 when the insertion protrusion 11 of the frame 2 is inserted into the opening 101.

Subsequently, as shown in FIG. 4B, the operator brings the packing 13 having been attached to the opposed portion 12 of the frame 2 into contact with the front wall surface 100a around the opening 101 in the wall 100. After that, the operator turns the cover 4 and exposes four corners (such as through holes 10a) of the front wall 10 of the frame 2 to the front. At this time, the male screw member 22 is not tightened with the female screw member 23. Subsequently, the operator rotates the male screw member 22 from the front wall surface 100a side of the wall 100 by use of a tool 105 such as a screwdriver. With this, the male screw member 22 and the female screw member 23 rotate integrally until the female screw member 23 abuts against the first stopper portion 31.

Referring to FIG. 2B and FIG. 3, the female screw member 23 is held at the first rotational position P1 by abutting against the first stopper portion 31. As a result, the second fastening portion 280 of the second part 282 of the extension portion 28 of the female screwmember 23 faces the first fastening portion 120 of the opposed portion 12 across the wall 100. Further rotated, the male screw member 22 relatively rotates with respect to the female screw member 23. Consequently, the female screw member 23 is displaced toward the wall 100 (the front X1). This makes the second fastening portion 280 which is the end surface of the second part 282 of the female screw member 23 contact with the rear wall surface 100b of the wall 100. As a result, the wall 100 is held by the second fastening portion 280 of the second part 282 of the female screw member 23 and the first fastening portion 120 of the opposed portion 12 of the frame 2, and the device 1 is mounted (fixed) on the wall 100.

When the device 1 having been mounted on the wall 100 is demounted from the wall 100, on the other hand, a reverse operation to the above is carried out. Specifically, the operator rotates the male screw member 22 in the opposite direction to that when the device 1 is mounted from the front wall surface 100a side of the wall 100. As a result, an axial force acting between the female screw member 23 and the male screw member 22 is released, and the female screw member 23 is displaced slightly rearward. Then, the contact between the female screw member 23 and the rear wall surface 100b of the wall 100 is released. After that, the female screw member 23 rotates integrally with the male screw member 22 by the frictional engagement force therebetween until the female screw member 23 abuts against the second stopper portion 32. It is noted that the frictional engagement force with the female screw member 23 may be improved by, for example, welding plastic on the male screw member 22.

When the extension portion 28 of the female screw member 23 comes into contact with the second stopper portion 32, the female screw member 23 is held at the second rotational position P2 as shown in FIG. 4A and FIG. 4B. Subsequently, the operator pulls the device 1 forward from the front wall surface 100a side of the device 1, thereby detaching the device 1 from the wall 100.
According to the present embodiment, as described above, the operator can attach and detach the device 1 to and from the wall 100 by manipulating the device 1 from the front wall surface 100a side of the wall 100. Thus, extending a hand around the rear wall surface 100b of the wall 100 is not necessary. In other words, the troublesome operation of turning hands around the both sides of the front wall surface 100a side and the rear wall surface 100b side of the wall 100, the operation of temporarily securing the device 1, and the operation by two persons are not required for the operation. The labor involved to attach and detach the device 1 (the labor of maintenance) can be reduced significantly.

Additionally, the insertion protrusion 11 of the device 1 can be inserted into the wall 100 with the male screw member 22 and the female screw member 23 attached to the frame 2. Consequently, there is no need to keep the male screw member 22, the female screw member, and the operating member separately from the frame 2. Accordingly, loss of parts of male screw member 22 and the female screw member 23 can be prevented.
In addition, the position of the second fastening portion 280 of the second part 282 of the female screw member 23 can be adjusted according to thickness of the wall 100. Therefore, the device 1 can be mounted on the wall 100 no matter what the thickness of the wall 100 is. Moreover, sealability between the wall 100 and the device 1 can be ensured by the packing 13 between the opposed portion 12 and the wall 100 regardless of the thickness of the wall 100. Consequently, sealing treatment for waterproofing and dustproofing from the back surface side of the device 1 is unnecessary.

The male screw member 22 also has the function as the operating mechanism which operates the female screw member 23. Thus, there is no need to operate the male screw member 22 and the member for controlling the rotational position of the female screw member 23 separately, so that the labor at the time of attaching and detaching the device 1 to and from the wall can be further saved. Additionally, the number of parts of the device 1 can be further reduced.
Since the frame 2 is provided with the first stopper portion 31, the female screw member 23 located at the first rotational position P1 can be restricted from further rotating when the male screw member 22 is rotated to fix the device 1 to the wall 100. Then, the female screw member 23 can be held at the first rotational position P1 reliably. The operator who performs the mounting operation of the device 1 from the front wall surface 100a side of the wall 100 can arrange the female screw member 23 at the first rotational position P1 reliably even if being unable to see the rotation direction position of the female screw member 23 arranged at the rear wall surface 100b side of the wall 100. Therefore, the operator can perform the mounting operation of the device 1 without anxiety even if being unable to see the female screwmember 23, and the labor of mounting the device 1 can be further saved.

Furthermore, since the frame 2 is provided with the second stopper portion 32, the female screw member 23 located at the second rotational position P2 can be restricted from further rotating when the male screw member 22 is rotated to detach the device 1 from the wall 100. Then, the female screw member 23 can be held at the second rotational position P2 reliably. The operator who performs the detaching operation of the device 1 from the front wall surface 100a side of the wall 100 can arrange the female screw member 23 at the second rotational position P2 reliably even if being unable to see the rotation direction position of the female screw member 23 arranged at the rear wall surface 100b side of the wall 100. Therefore, the female screw member 23 can be reliably prevented from catching on the wall when the operator detaches the device 1, even if the operator cannot see the female screw member 23, and the labor of demounting the device 1 can be further saved.

The female screwmember 23, the first stopper portion 31, and the second stopper portion 32 can be prevented from projecting outward from the insertion protrusion 11 by being arranged within the housing recess 18. This can reliably prevent the female screw member 23 from facing the opposed portion 12 of the frame 2 when the female screw member 23 is located at the second rotational position P2. Accordingly, the female screw member 23 can be more reliably prevented from being caught when the frame 2 of the device 1 is inserted into the wall 100, and the labor of mounting the device 1 can be further saved. In addition, the device 1 can be further downsized. Moreover, the thickness of the insertion protrusion 11 can be reduced, so that a reduction in thickness of the device can be achieved.

Further, the length of the female screw portion 251 can be increased by forming the female screw portion 251 at the cylindrical portion 25. With this, the contact area between the male screw member 22 and the female screw member 23 can be further enlarged, so that the frictional engagement force between the male screw member 22 and the female screw member 23 can be sufficiently ensured. Thus, the female screw member 23 can be reliably rotated when desired to be rotated along with the rotation of the male screw member 22 (when desired to be displaced between the first rotational position P1 and the second rotational position P2).

In addition, the holding hole 21a formed in the frame 2 holds the cylindrical portion 25 rotatably. As a result, the central axis of the male screw member 22 and the female screw member 23 can be prevented from swaying while the male screw member 22 and the female screw member 23 are rotated. Thus, the male screw member 22 and the female screw member 23 can be rotated smoothly. The labor of mounting the device 1 can be further saved.

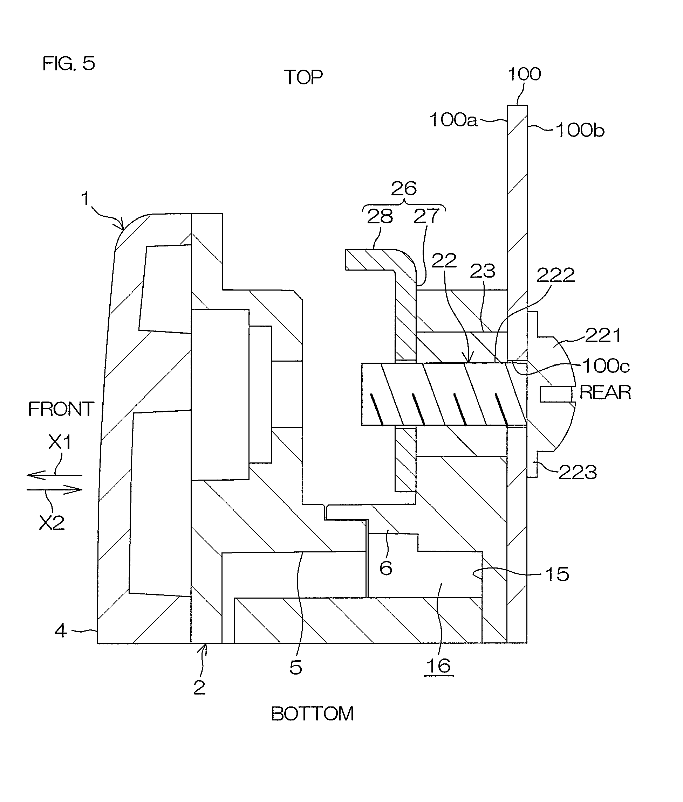

The present invention should not be restricted to the above embodiment and can be modified in various ways within the scope of claims. In the following, points of difference with the foregoing embodiment will be mainly described. The same components as those of the foregoing embodiment will be given the same reference symbols as those of the foregoing embodiment in the drawings, and detailed descriptions thereof will be omitted.
For example, the device 1 may be fixed to the front wall surface 100a of the wall 100, as shown in a reference form of FIG. 5. The female screw member 23 is opened to the rear surface of the device 1. The wall 100 is formed with a screw insertion hole 100c. When the device 1 is mounted on the wall 100, the rear wall 15 of the device 1 is brought into contact with the front wall surface 100a of the wall 100. In this state, the male screw member 22 is inserted into the screw insertion hole 100c. The male screw member 22 is then engaged with the female screw member 23 from the rear wall surface 100b side of the wall 100. As a result, the device 1 can be mounted on the wall 100.

As already described above, the device 1 can be mounted from the front wall surface 100a side of the wall 100, and also from the rear wall surface 100b side of the wall 100 as shown in the reference form of FIG. 5. As a result, mounting versatility of the device 1 can be further enhanced. Further, the device 1 can be mounted on the wall 100 without forming the opening 101 in the wall 100.

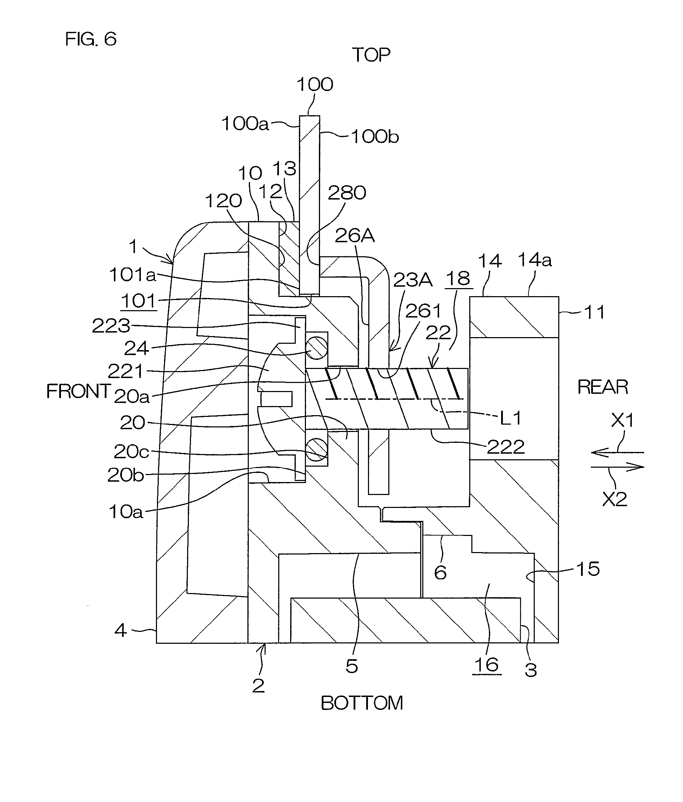

Instead of the female screwmember 23, a female screw member 23A may be used as shown in FIG. 6. This female screw member 23A differs from the female screw member 23 in that the cylindrical portion 25 is omitted and that a female screwportion 261 is formed at a small piece member 26A. In this case as well, the thread engagement between the male screw member 22 and the female screw member 23A allows the female screw member 23A to be displaced with respect to the wall 100 in the front-rear direction.

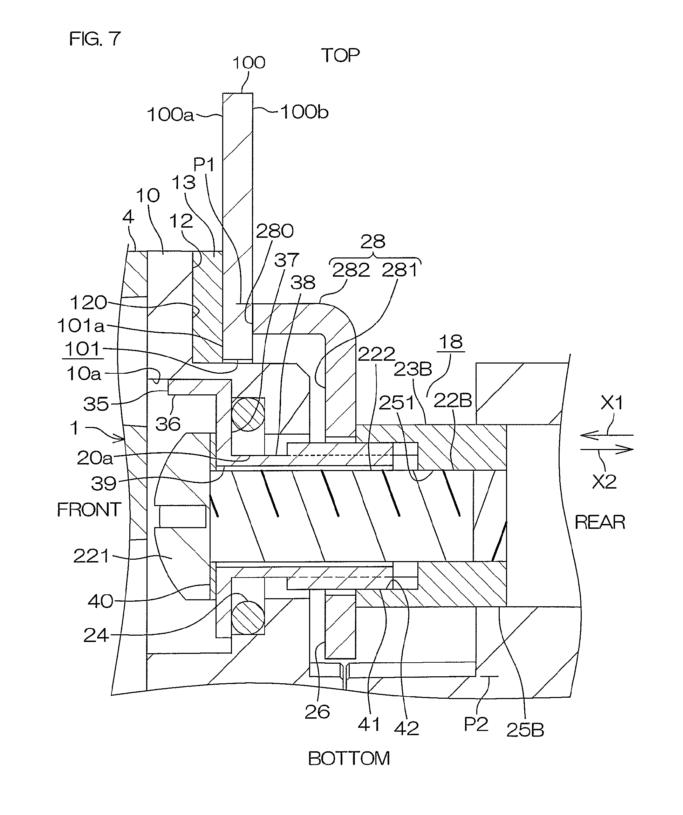

Further, instead of the male screw member 22 and the female screw member 23 of the embodiment in FIG. 3, a male screw member 22B, a female screw member 23B, and an operating member 35 may be provided as shown in an embodiment of FIG. 7.
The male screw member 22B has the same configuration as the male screw member 22 except that the flange portion 223 is not provided. The operating member 35 is such a member that is formed separately from the male screw member 22B and the female screw member 23B. The operating member 35 includes a protruding operating portion 36 arranged in the through hole 10a, a flange portion 37 to which the operating portion 36 is attached, and an operating member main body 38 extending rearward from the flange portion 37.

As for the rotational direction of the female screw member 23B, the position of the operating portion 36 and the position of the extension portion 28 of the female screw member 23B are aligned. The flange portion 37 is formed with a screw insertion hole 39, into which the male screw member 22B is inserted. The flange portion 37 receives the head portion 221 of the male screw member 22B via a packing 40. The flange portion 37 is in contact with the seal member 24.

The operating member main body 38 is inserted into the screw insertion hole 20a. The operating member main body 38 is formed with the screw insertion hole 39. The operating member main body 38 has an outer peripheral surface formed with a first coupling portion 41 extending along the axial direction of the male screw member 22B. The first coupling portion 41 is a protrusion and, for example, arranged at two places evenly spaced in the circumferential direction.
The female screw member 23B has a cylindrical portion 25B and the small piece portion 26. The cylindrical portion 25B includes a second coupling portion 42 coupled to the first coupling portion 41 and the female screw portion 251 arranged at the rear of the second coupling portion 42 and threadedly engaged with the male screw portion 222.

The second coupling portion 42 is a groove extending along the axial direction of the male screw member 22B. The second coupling portion 42 is coupled to the corresponding first coupling portion 41. Therefore, the operating member 35 is coupled so as to be rotatable integrally with the female screw member 23B and relatively movable in the axial direction. Then, the rotation direction position of the female screw member 23B can be defined by the operating member 35. Further, the female screw member 23B can be displaced in the front-rear direction by rotating the male screw member 22B.

According to this embodiment, the rotational position of the female screw member 23 can be displaced reliably at any desired position such as the first rotational position P1 or the second rotational position P2 by controlling the operating portion 36 from the front wall surface 100a side of the wall 100. Furthermore, as for the rotational direction of the female screw member 23B, the position of the operating portion 36 and the position of the extension portion 28 of the female screw member 23B are aligned. Thus, the position of the extension portion 28 of the female screw member 23B can be grasped reliably without seeing the female screw member 23B. Consequently, the attaching and detaching of the device 1 with respect to the wall 100 can be performed more easily.

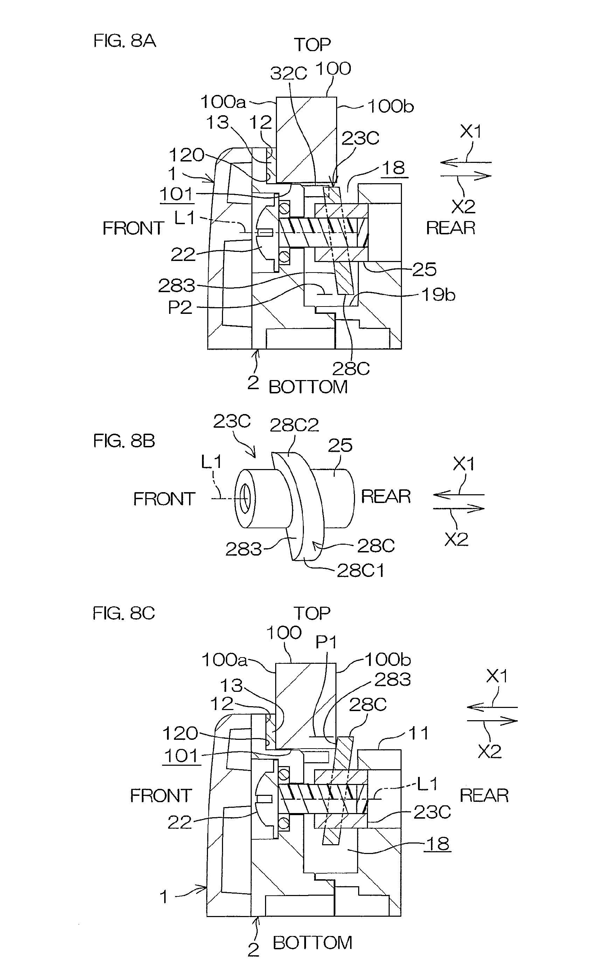

In place of the female screw member 23 of the embodiment in FIG. 3, a female screw member 23C may be used as shown in an embodiment of FIG. 8A and FIG. 8B. The female screw member 23C includes the cylindrical portion 25 and an extension portion 28C extending from an outer peripheral surface of the cylindrical portion 25. The extension portion 28C is fixed at a circumferential part of the cylindrical portion 25. As for the circumferential direction of the cylindrical portion 25, the extension portion 28C is arranged in the range of 180 degrees or less (approximately 180 degrees in this embodiment), for example.

The extension portion 28C has a second fastening portion 283. The second fastening portion 283 is configured to face the rear wall surface 100b of the wall 100 and the first fastening portion 120 of the opposed portion 12 when the female screw member 23c is located at the first rotational position P1.
The second fastening portion 283 is formed spirally about the screw axis L1. More specifically, the second fastening portion 283 is formed in such a spiral shape that heads for the rear X2 along the rotational direction of the male screw member 22 at the time of mounting the device 1 on the wall 100 (the clockwise direction when the device 1 is viewed from the front in this embodiment).

The extension portion 28C corresponds to the relatively distant part from the screw axis L1 and the cylindrical portion 25 corresponds to the relatively near part from the screw axis L1. The extension portion 28C also has a relatively distant part 28C1 from the screw axis L1 and a relatively near part 28C2 from the screw axis L1. The second fastening portion 283 is provided to the relatively distant part 28C1 from the screw axis L1.

The frame 2 is provided with a second stopper portion 32C. The second stopper portion 32C is a protrusion provided to the seat 20, and is configured to contact with the extension portion 28C being located at the second rotational position P2.
The extension portion 28C is arranged within the housing recess 18 when the female screw member 23C is located at the second rotational position P2. From this state, the male screw member 22 is rotated to rotate the female screw member 23C in order to fix the device 1 to the wall 100, whereupon the female screw member 23C is displaced to the first rotational position P1 as shown in FIG. 8C. Then, the extension portion 28C protrudes outside the housing recess 18. At this time, the female screw member 23C rotates until the second fastening portion 283 of the extension portion 28C comes into contact with the rear wall surface 100b of the wall 100. Upon contact of the second fastening portion 283 with the rear wall surface 100b of the wall 100, the rotation of the female screw member 23C is restricted. The male screw member 22 is further rotated in this state, whereby the female screw member 23C is displaced forward and the second fastening portion 283 and the first fastening portion 120 of the opposed portion 12 hold the wall 100 therebetween.

In this case, a part corresponding to the thickness of the wall 100, of the second fastening portion 283 of the extension portion 28C is configured to come into contact with the rear wall surface 100b of the wall 100 when the female screw member 23C is rotated with the insertion protrusion 11 inserted in the opening 101. As a result, the female screw member 23C can be displaced from the second rotational position P2 to the first rotational position P1, and at the same time, the extension portion 28C can be brought into contact with the rear wall surface 100b of the wall 100. Since there is no need to rotate the male screw member 22 to axially displace the male screw portion 222 in order to bring the extension portion 28C into contact with the rear wall surface 100b of the wall 100, the number of rotations of the male screw member 22 can be reduced, and the labor involved to mount the device 1 can be further saved.

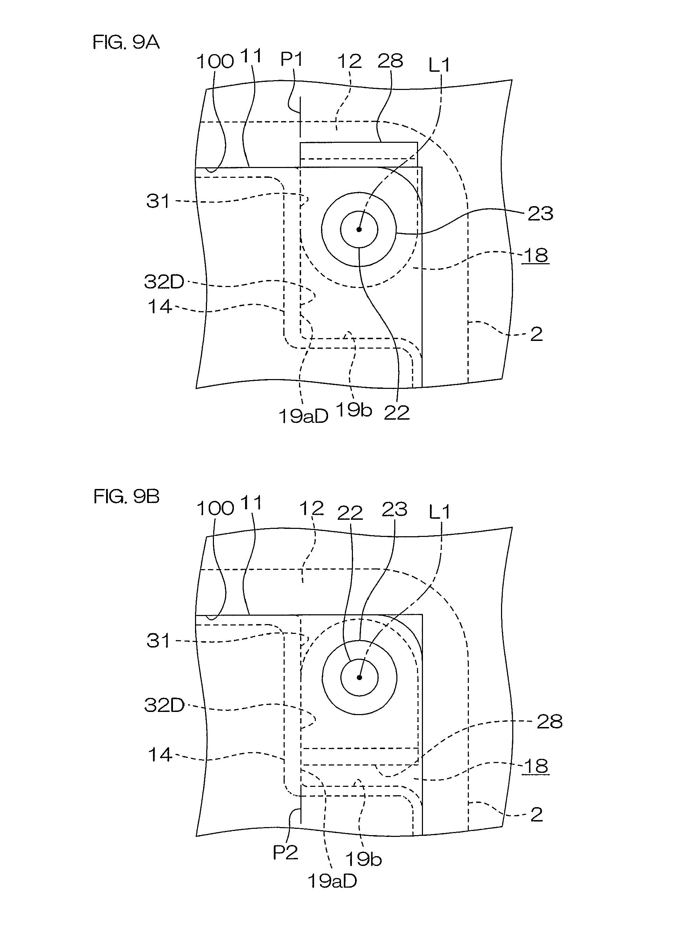

Further, instead of the second stopper portion 32 of the embodiment in FIG. 3, a second stopper portion 32D may be provided as shown in the embodiment in FIG. 9A and FIG. 9B. Then, the female screw member 23 can be restricted from further rotating toward the second stopper 32D when contacting with the second stopper portion 32D.
The second stopper portion 32D is formed on a first surface 19aD of an L-shaped lateral surface 19D. The first surface 19aD has a longer vertical length than the first surface 19a (see FIG. 2B). Therefore, the second stopper portion 32D is arranged in the same plane as the first stopper portion 31.

The female screw member 23 is rotatable in the range of substantially 180 degrees. The female screw member 23 rotates substantially 180 degrees from the first rotational position P1 about the central axis L1, thereupon contacting with the second stopper portion 32D as shown in FIG. 9B and being restricted from rotating at the second rotational position P2.
In this case, the first stopper portion 31 and the second stopper portion 32D are formed in the same plane (the first surface 19aD). As a result, the relative position of the first rotational position P1 and the second rotational position P2, that is, a rotatable angle range of the female screw member 23 about the central axis L1 can be defined more accurately.

In each of the foregoing embodiments, the small piece portion 26, 26A may be formed into a shape other than the L shape, for example, a flat plate shape.
Further, the configuration that the right upper portion and the left lower portion of the device 1 are fixed to the wall 100 is described in each of the foregoing embodiments. However, it should not be restricted to that. For example, four corners of the device 1 may be fixed to the wall 100.

Further, the packing 13 may be eliminated and the first fastening portion 120 and the second fastening portion 280 may fasten the wall 100 directly in each of the foregoing embodiments.
Further, the first screw member is the male screw member and the second screw member is the female screw member in each of the foregoing embodiments. However, the first screw member may be the female screw member and the second screw member may be the male screw member, instead.

Further, the first direction is toward the front and the second direction is toward the rear in each of the foregoing embodiments. However, the first direction may be toward the rear and the second direction may be toward the front, instead.
Although the present invention has heretofore been described in detail based on the specific modes, variations, modifications, and equivalents thereof will readily occur to those skilled in the art who understand the foregoing descriptions. Therefore, the present invention should cover the scope of claims and equivalents thereof.

This application corresponds to Japanese Patent Application No. 2010-236630, filed with the Japan Patent Office on Oct. 21, 2010, the entire disclosure of which is incorporated herein by reference.

### Description of Reference Symbols

- 1: Device

- 2: Frame
- 11: Insertion protrusion
- 12: Opposed portion
- 120: First fastening portion
- 14a: Outer surface (of insertion portion)
- 18: Housing recess
- 20a: Screw insertion hole (of frame)
- 21a: Holding hole (holding portion)
- 22; 22B: Male screwmember (first screwmember, operating mechanism)
- 221: Head portion (operating portion)
- 23; 23A; 23B; 23C: Female screw member (second screw member)
- 231: External shape of female screw member
- 25; 25B: Cylindrical portion
- 251: Female screw portion
- 28; 28C: Extension portion
- 280; 283: Second fastening portion
- 31: First stopper portion (stopper portion)
- 32; 32C; 32D: Second stopper portion (stopper portion)
- 35: Operating member (operating mechanism)
- 36: Operating portion
- 100: Wall
- 101: Opening
- 100a: Front wall surface (first wall surface)
- 100b: Rear wall surface (second wall surface)
- 101a: Peripheral portion
- L1: Screw axis
- P1: First rotational position
- P2: Second rotational position

## Claims

1. A wall-mountable device that is mountable on a wall having a first wall surface directed to a first direction and a second wall surface directed to a second direction as an opposite direction of the first direction and formed with an opening penetrating the first wall surface and the second wall surface, the device comprising:
a frame;
a first screw member and a second screw member coupled to each other on a screw axis in order to attach the frame to the wall; and
an operating mechanism comprising an operating portion exposable from the frame toward the first direction, the operating mechanism being capable of controlling a rotational position of the second screw member about the screw axis between a first rotational position and a second rotational position by operating the operating portion;
wherein the frame comprises an opposed portion arranged so as to face the first wall surface of the wall; and an insertion protrusion protruding from the opposed portion toward the second direction and being insertable into the opening,
the opposed portion has a first fastening portion configured to face a periphery of the opening of the first wall surface,
the insertion protrusion forms an insertion hole extending along the screw axis,
the first screw member is inserted into the insertion hole along the second direction and threadedly engaged with the second screw member,
the second screw member comprises a second fastening portion configured to face the first fastening portion at the first rotational position and avoid facing the first fastening portion at the second rotational position, and
the wall is fastened directly or indirectly between the first fastening portion of the opposed portion and the second fastening portion of the second screw member having been displaced to the first rotational position.

2. The wall-mountable device according to claim 1, wherein the second screw member comprises a relatively distant part and a relatively near part from the screw axis, and the relatively distant part comprises the second fastening portion.

3. The wall-mountable device according to either claim 1 or 2, wherein the operating mechanism comprises a male screw member as the first screw member and threadedly engaged with a female screw member as the second screw member, and the male screw member as the operating mechanism is configured to be capable of controlling a position of the female screw member via a frictional engagement force between the male screw member and the female screw member.

4. The wall-mountable device according to either claim 1 or 2, wherein the operating mechanism comprises an operating member integrally rotatably coupled to the second screw member, and the operating member extends from the second screw member toward the first direction through the insertion hole in the insertion protrusion.

5. The wall-mountable device according to any one of claims 1 to 4, wherein the frame comprises a stopper portion for holding the second screw member at the first rotational position.

6. The wall-mountable device according to any one of claims 1 to 5, wherein the frame comprises a stopper portion for holding the second screw member at the second rotational position.

7. The wall-mountable device according to claim 5 or 6, wherein the insertion protrusion has an outer surface, part of which is formed with a housing recess housing the second screw member, and the stopper portion is arranged within the housing recess.

8. The wall-mountable device according to any one of claims 1 to 7, wherein the female screw member as the second screw member comprises a cylindrical portion having a female screw portion engaged with the male screw member as the first screw member; and an extension portion extending radially outward from the cylindrical portion, and the second fastening portion is provided to the extension portion.

9. The wall-mountable device according to claim 8, wherein the frame comprises a holding portion rotatably holding the cylindrical portion.
